# FASCICULE DE BREVET EUROPEEN

(11) **EP 1 016 136 B1**
(45) Date de publication et mention de la délivrance du brevet: **04.12.2002**
(21) Numéro de dépôt: 98943967.4
(22) Date de dépôt: 11.09.1998
(51) Int. Cl.: H01L 21/763

(54) **STRUCTURE MICROELECTRONIQUE COMPORTANT UNE PARTIE DE BASSE TENSION MUNIE D'UNE PROTECTION CONTRE UNE PARTIE DE HAUTE TENSION ET PROCEDE D'OBTENTION DE CETTE PROTECTION**
Eine mikroelektronische Struktur mit einem Niedrigspannungsteil, das gegen ein Hochspannungsteil geschützt ist und ein Herstellungsverfahren von dieser Schutzstruktur
MICROELECTRONICS STRUCTURE COMPRISING A LOW VOLTAGE PART PROVIDED WITH PROTECTION AGAINST A HIGH VOLTAGE PART AND METHOD FOR OBTAINING SAID PROTECTION

(30) Priorité: 12.09.1997 FR 9711390
(43) Date de publication de la demande: 05.07.2000
(73) Titulaire: COMMISSARIAT A L'ENERGIE ATOMIQUE, 75015 Paris (FR)
(72) Inventeur: GIFFARD, Benoit, F-38000 Grenoble (FR)
(74) Mandataire: Ilgart, Jean-Christophe
(86) Numéro de dépôt international: FR9801948
(87) Numéro de publication internationale: WO99014803

(56) Documents cités:
- DE-A- 3 223 842
- US-A- 5 420 061
- PATENT ABSTRACTS OF JAPAN vol. 016, no. 227 (E-1207), 26 mai 1992 -& JP 04 042959 A (FUJITSU LTD), 13 février 1992

## Description

### DOMAINE TECHNIQUE

La présente invention concerne une structure microélectronique comprenant :
- au moins un élément de basse tension et au moins un élément de haute tension et
- des moyens de protection destinés à protéger l'élément de basse tension contre des effets parasites engendrés au niveau de l'élément de haute tension et notamment des effets des commutations de l'élément de haute tension.

La présente invention s'applique notamment au domaine de l'électronique de puissance et plus particulièrement aux circuits intégrés de puissance intelligents (« smart power integrated circuits »).

### ÉTAT DE LA TECHNIQUE ANTÉRIEURE

Avec de tels circuits se pose le problème de la protection du ou des éléments de basse tension (qui sont généralement des éléments de commande, par exemple des circuits logiques de commande) en particulier contre des phénomènes transitoires résultant des commutations de l'élément ou des éléments de haute tension (qui sont les éléments de puissance).

Lors d'une commutation d'un élément de haute tension, cet élément subit de très importantes variations de tension et de courant : la tension peut varier de plusieurs centaines de volts et le courant de plusieurs ampères.

Cela engendre des impulsions parasites de courant et de tension dans tout le circuit.

Ces impulsions sont susceptibles de perturber le ou les éléments de basse tension qui sont beaucoup plus sensibles à de telles impulsions qu'un élément de haute tension.

On connaît plusieurs solutions pour résoudre ce problème.

Une première solution consiste à éloigner le ou les éléments de basse tension du ou des éléments de haute tension.

Une telle solution présente un inconvénient : elle nécessite l'utilisation d'une grande surface de matériau semiconducteur.

Une deuxième solution consiste à limiter la tension et le courant de fonctionnement du ou des éléments de haute tension, ce qui est gênant pour les performances du circuit.

Une troisième solution consiste à isoler le ou les éléments de basse tension dans des caissons électriquement isolants ce qui présente un inconvénient car le procédé de fabrication du circuit est alors complexe.

Une quatrième solution consiste à former des zones peu résistives (zones semiconductrices très dopées) sous le ou les éléments de basse tension afin de « drainer » les courants parasites provenant du substrat.

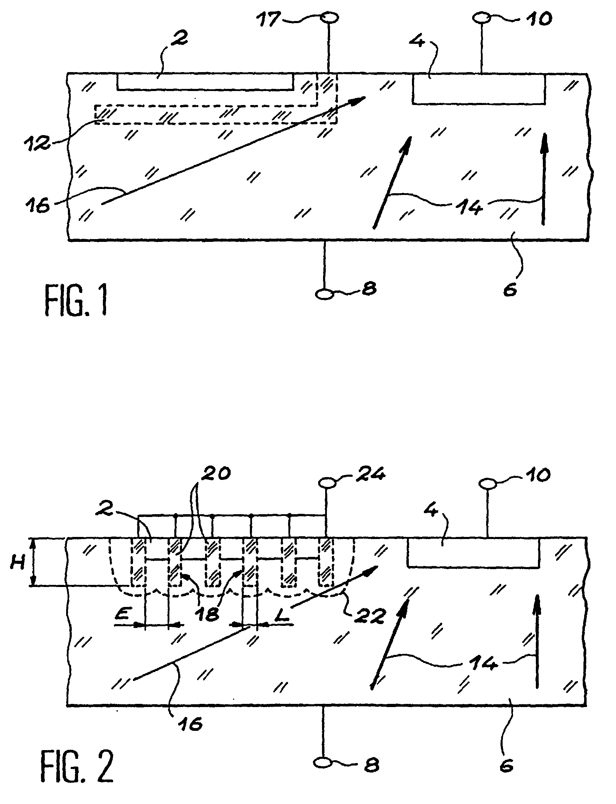

Cette quatrième solution est illustrée par la figure 1.

Sur cette figure 1 on a représenté en coupe transversale schématique un circuit de puissance comprenant :
- une zone de basse tension 2 comprenant un ou une pluralité d'éléments de basse tension et
- une zone de haute tension 4 comprenant un ou une pluralité d'éléments de haute tension.

Ces zones 2 et 4 sont formées sur la surface supérieure d'un substrat semiconducteur 6.

Une prise de contact 8 est prévue à la face inférieure de ce substrat 6 pour l'arrivée d'un fort courant et l'établissement d'une haute tension.

On voit également sur la figure 1 une prise de contact 10 prévue pour la sortie d'un fort courant de la zone de haute tension 4.

Conformément à la quatrième solution mentionnée plus haut une zone très dopée 12 est formée sous la zone de basse tension 2 et constitue un écran de protection de cette dernière.

Les flèches 14 que l'on voit sur la figure 1 représentent les courants électriques engendrés dans le substrat lors du fonctionnement de la zone de haute tension.

La flèche 16 représente un courant de puissance parasite qui est capté par la zone très dopée 12.

On voit aussi sur la figure 1 une prise de contact 17 prévue pour la sortie du courant parasite de cette zone très dopée 12.

La zone très dopée 12 est une zone enterrée qui est réalisée par dopage de surface puis épitaxie sur toute la tranche de matériau semiconducteur (généralement le silicium) sur laquelle est formée le circuit.

La quatrième solution présente des inconvénients :
- pour sa mise en oeuvre elle nécessite une épitaxie qui est un procédé coûteux et délicat,
- l'épitaxie ayant lieu à haute température il se produit une diffusion des dopants,
- l'architecture du circuit est alors complexe car le
ou les éléments de haute tension doivent être réalisés dans le matériau résultant de l'épitaxie.

De plus, la prise de contact avec la zone enterrée très dopée est d'autant plus difficile à réaliser que cette zone est enterrée plus profondément.

### EXPOSÉ DE L'INVENTION

La présente invention selon les revendications 1 et 15 a pour but de remédier aux inconvénients précédents.

On connaît, par US-A-5420061, un procédé de protection d'une structure microélectronique. On connaît également, par DE-A-3223842, un dispositif semiconducteur comportant des tranchées. On connaît en outre, par JP-A-04042959, une structure microélectronique, munie de moyens de protection, et un procédé de fabrication de cette structure.

L'invention a pour objet une structure microélectronique comprenant :
- au moins un élément de basse tension et au moins un élément de haute tension qui sont formés sur un substrat semiconducteur ayant un premier type de dopage et
- des moyens de protection destinés à protéger l'élément de basse tension contre les effets parasites engendrés au niveau de l'élément de haute tension,
cette structure étant caractérisée en ce que les moyens de protection comprennent :
- au moins une tranchée qui traverse l'élément de basse tension,
- une zone semiconductrice qui a un deuxième type de dopage opposé au premier type de dopage et qui au moins entoure les parois de la ou des tranchées, de façon à ce que cette ou ces tranchées permettent de drainer les courants parasites engendrés au niveau de l'élément de haute tension, et
- une prise de contact sur cette zone, cette prise de contact permettant la sortie des courants parasites.

Selon un mode de réalisation avantageux, la ou les tranchées pénètrent dans le substrat.

Selon un mode de réalisation particulier, l'élément de basse tension comprend un caisson semiconducteur ayant le deuxième type de dopage et chaque tranchée est formée dans ce caisson et pénètre dans le substrat.

Le fait que les tranchées pénètrent dans le substrat permet un drainage plus efficace des courants parasites (un draînage des zones éloignées-des éléments actifs basse tension pour minimiser les effets parasites sur ces éléments basse tension).

Selon un premier mode de réalisation de la structure de l'invention, ladite zone est une partie du substrat et est dopée par un dopant de type opposé au reste du substrat, tout autour de la tranchée.

De préférence, la prise de contact sur cette partie est réalisée par un dépôt conducteur qui remplit partiellement ou totalement la tranchée.

Selon un deuxième mode de réalisation de la structure de l'invention, ladite zone comporte un matériau semi-conducteur, de type de dopant opposé à celui du substrat, déposé dans la tranchée, ce matériau remplissant totalement ou partiellement celle-ci et la partie du substrat au voisinage des parois de la tranchée dans laquelle le dopant a diffusé.

De préférence, la prise de contact dans ce deuxième mode de réalisation est réalisée par un dépôt conducteur sur ledit matériau, ce dépôt conducteur étant susceptible de compléter le remplissage de la tranchée.

Il est à noter que le dépôt conducteur (quel que soit le mode de réalisation) permettant la réalisation de la prise de contact peut ne pas recouvrir entièrement ladite zone.

Selon un mode de réalisation particulier de la structure microélectronique objet de l'invention, les tranchées entourent au moins un composant électronique faisant partie de l'élément de basse tension.

Dans la structure microélectronique objet de l'invention, au moins une tranchée peut être continue ou, au contraire, discontinue.

De préférence, la profondeur de chaque tranchée au-delà de l'élément de basse tension va de quelques micromètres à une dizaine de micromètres.

De préférence également, la largeur de chaque tranchée est de l'ordre de 2 µm à 5 µm.
Le substrat est de préférence en silicium et le matériau servant à remplir les tranchées peut alors être du polysilicium dopé dont le dopage est opposé à celui du silicium du substrat.

En variante, ce matériau peut être du verre dopé dont le dopage est opposé à celui du silicium du substrat.

Dans ce cas, la prise de contact peut être formée par du polysilicium dopé ou non dopé.

La présente invention a également pour objet un procédé de protection d'une structure microélectronique comprenant au moins un élément de basse tension et au moins un élément de haute tension qui sont formés sur un substrat semiconducteur ayant un premier type de dopage, ce procédé étant caractérisé en ce qu'il comprend les étapes suivantes :
- on forme une couche protectrice à la surface de la structure,
- on forme au moins une tranchée à travers la couche protectrice et l'élément de basse tension,
- on forme une zone semiconductrice présentant un deuxième type de dopage opposé au premier type, au moins autour des parois de la ou des tranchées, de façon à ce que cette ou ces tranchées permettent de drainer les courants parasites engendrés au niveau de l'élément de haute tension, et
- on réalise une prise de contact sur ladite zone, cette prise de contact permettant la sortie des courants parasites.

Selon un premier mode de réalisation particulier, ladite zone est réalisée par implantation dans le substrat à travers les parois, d'un dopant de type opposé à celui du substrat.

De préférence, après implantation le dopant est activé par traitement thermique.

Selon un deuxième mode de réalisation particulier, ladite zone est réalisée par dépôt d'un matériau d'un type de dopage opposé à celui du substrat et traitement thermique de la structure, ce traitement thermique étant apte à faire diffuser le dopant vers l'extérieur de la ou des tranchées.

Quel que soit le mode de réalisation de ladite zone, la prise de contact est formée par dépôt d'un matériau conducteur qui peut éventuellement compléter le remplissage de la tranchée.

La couche protectrice peut être conservée ou éliminée après réalisation de la structure.

Selon un mode de mise en oeuvre particulier du procédé objet de l'invention, l'élément de basse tension comprend :
- un caisson semiconducteur ayant le deuxième type de dopage,
- des zones espacées, électriquement isolantes à la surface du caisson et
- au moins un composant électronique formé dans le caisson, dans un espace compris entre deux des zones,
et les tranchées sont formées à travers des espaces séparant ces deux zones de zones isolantes adjacentes.

### BRÈVE DESCRIPTION DES DESSINS

La présente invention sera mieux comprise à la lecture de la description d'exemples de réalisation donnés ci-après, à titre purement indicatif et nullement limitatif, en faisant référence aux dessins annexés sur lesquels :
- la figure 1 est une vue en coupe transversale schématique d'une structure microélectrique protégée de façon connue et a déjà été décrite,
- la figure 2 est une vue en coupe transversale schématique d'une structure microélectrique protégée conformément à l'invention,
- les figures 3 à 6 illustrent schématiquement différentes étapes d'un procédé de protection conforme à l'invention, et
- la figure 7 est une vue de dessus schématique d'une structure microélectronique conforme à l'invention.

### EXPOSÉ DÉTAILLÉ DE MODES DE RÉALISATION PARTICULIERS

La structure microélectronique conforme à l'invention qui est schématiquement représentée en coupe transversale sur la figure 2 diffère de la structure de la figure 1 par le fait que la zone très dopée 12 et la prise de contact 17 de celle-ci sont supprimées.

A la place de cette zone très dopée, on a prévu dans la structure de la figure 2, pour protéger l'élément de basse tension 2, des tranchées 18 qui traversent cet élément de basse tension et sont suffisamment profondes pour pénétrer dans le substrat 6.

Ces tranchées sont remplies d'un matériau semiconducteur 20 dont le dopage est opposé à celui du substrat 6.

Par exemple, si le substrat est de type N, ce matériau est de type P.

Ces tranchées remplies du matériau 20 permettent de drainer les courants parasites 16 qui traversent le substrat 6 en particulier lors des commutations de l'élément de haute tension 4 et coopèrent pour former un écran 22 qui protège l'élément de basse tension 2 des variations de haute tension provenant du substrat lors de ces commutations.

Cet écran vis-à-vis des variations de tension et ce drainage des courants parasites sont d'autant mieux réalisés que l'espace E entre les tranchées est plus faible car l'effet d'influence dû à ces tranchées remplies du matériau est alors plus important.

On voit aussi sur la figure 2 une prise de contact 24 à laquelle sont reliées toutes les tranchées remplies du matériau 22 et qui permet la sortie du courant parasite 16 capté par ces tranchées.

On explique maintenant un exemple de procédé conforme à l'invention pour la protection de la structure de la figuré 2 c'est-à-dire pour la formation des tranchées.

On commence par former une couche protectrice à la surface supérieure de la structure.

Cette couche protectrice est par exemple une couche d'oxyde de silicium lorsque le substrat est en silicium.

On forme ensuite par masquage et gravure les tranchées profondes dans cette couche protectrice puis dans l'élément de basse tension jusqu'à ce que ces tranchées atteignent le substrat.

On donne aux tranchées une largeur L de l'ordre de 2 à 5 µm et une profondeur H supérieure à la profondeur de l'élément de basse tension, cette profondeur étant par exemple égale à 10 µm.

On effectue éventuellement une oxydation de 50 nm environ puis une désoxydation de façon à nettoyer la surface des tranchées par consommation du silicium (oxyde sacrificiel).

On remplit ensuite les tranchées (remplissage conforme), dans le cas où le substrat est du silicium ayant un dopage de type N, par du polysilicium dopé avec du bore « in situ ».

Le dopage du polysilicium est par exemple de l'ordre de 10¹⁹ à 10²⁰ ions cm⁻³.

En variante on commence par remplir les tranchées par une couche de verre dopé par du bore (verre de type BSG pour « Boron Silicon Glass »), avec un dopage de l'ordre de 10²⁰ cm⁻³, puis on complète le remplissage des tranchées avec du polysilicium dopé ou non dopé qui formera la prise de contact.

On élimine ensuite par gravure le polysilicium ou le BSG se trouvant à la surface de la structure semiconductrice puis on élimine éventuellement par gravure la couche protectrice.

De préférence, on effectue un recuit de la structure juste avant l'élimination du matériau de remplissage se trouvant à la surface de celle-ci ou juste après cette élimination afin que le dopant (bore dans l'exemple considéré) puisse diffuser légèrement à l'intérieur du substrat au voisinage des tranchées.

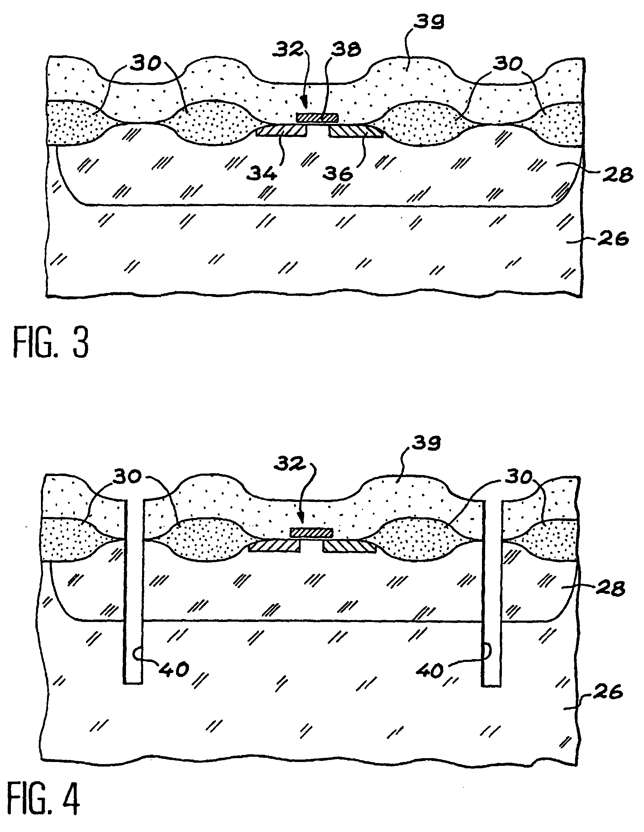

Les figures 3 à 6 illustrent schématiquement ce procédé dans le cas d'une structure microélectronique formée sur un substrat 26 en silicium de type N (figure 3).

A la surface supérieure du substrat 26 se trouve une zone de type P constituant un caisson P (« P well ») référencé 28.

Des couches d'oxyde de silicium 30 obtenues par un procédé connu appelé LOCOS sont formées au-dessus du caisson 28 et espacées les unes des autres.

Dans le caisson 28 sont réalisés de façon classique un ou plusieurs transistors de type NMOS.

Dans l'exemple représenté sur la figure 3 on a réalisé un seul transistor 32 et l'on voit la source 34 de type N+, le drain 36 également de type N+ et la grille 38 en polysilicium de ce transistor.

Ce dernier est formé dans une zone du caisson qui est comprise entre deux couches d'oxyde 30.

Conformément au procédé objet de l'invention on forme une couche protectrice en oxyde de silicium 39 au-dessus des couches 30 et du ou des transistors.

Il est à noter que l'on n'a pas encore formé les contacts du transistor et de façon générale de la structure et en particulier on n'a pas réalisé le dépôt de métal nécessaire à ces contacts.

Comme le montre schématiquement la figure 4 on forme ensuite deux tranchées 40 par photolithographie et gravure anisotrope de la couche d'oxyde 39 et du silicium du caisson et du substrat puis on élimine la résine photosensible « photoresist ») ayant servi à la photolithographie.

On voit que ces tranchées traversent le caisson et sont formées au niveau des espaces séparant les deux couches d'oxyde 30, entre lesquelles se trouve le transistor, des deux couches d'oxyde 30 adjacentes.

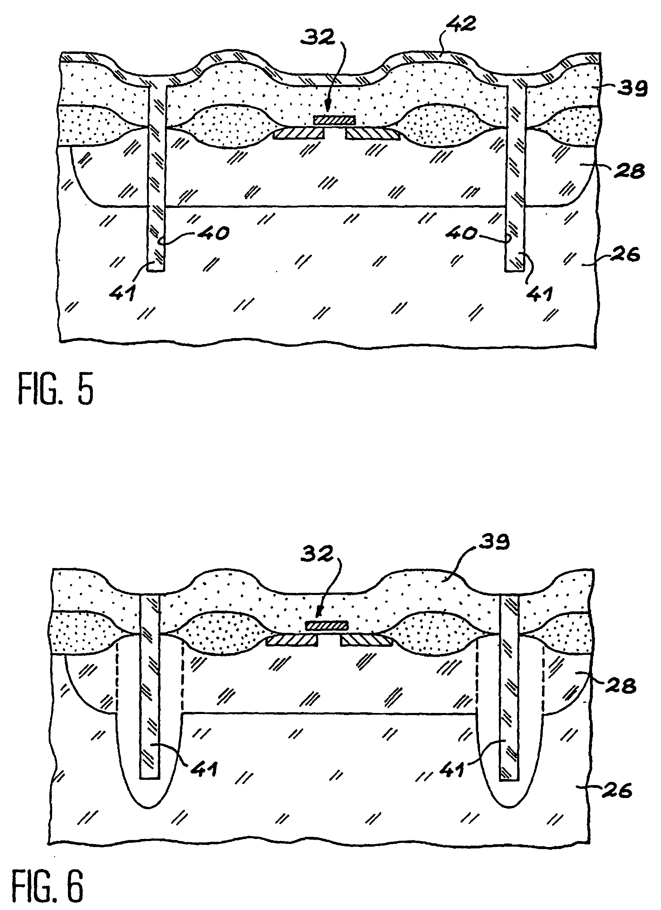

Comme le montre schématiquement la figure 5 on réalise ensuite un dépôt conforme, par dépôt chimique en phase vapeur d'un matériau constitué par du polysilicium dopé au bore (dopage « in-situ »), de manière à remplir les tranchées de ce matériau 41.

On voit qu'une couche 42 de polysilicium dopé au bore subsiste à la surface de la couche d'oxyde 39.

Comme le montre schématiquement la figure 6 on élimine cette couche 42 de polysilicium dopé au bore par gravure puis on effectue un recuit de la structure obtenue afin que le dopant (bore) diffuse dans le silicium et plus précisément dans le caisson P et dans le silicium de type N situé au-dessous de ce caisson.

Dans ce mode de réalisation la couche de protection 39 est conservée.

On achève ensuite le procédé par une ouverture de contacts puis une ou plusieurs métallisations de façon classique.

Cette métallisation est destinée à former les divers contacts de la structure microélectronique notamment pour le ou les transistors 32 de l'élément de basse tension, pour les composants se trouvant dans l'élément de haute tension (non représenté) que contient également cette structure, pour la face-arrière du substrat et pour les tranchées remplies du matériau 41.

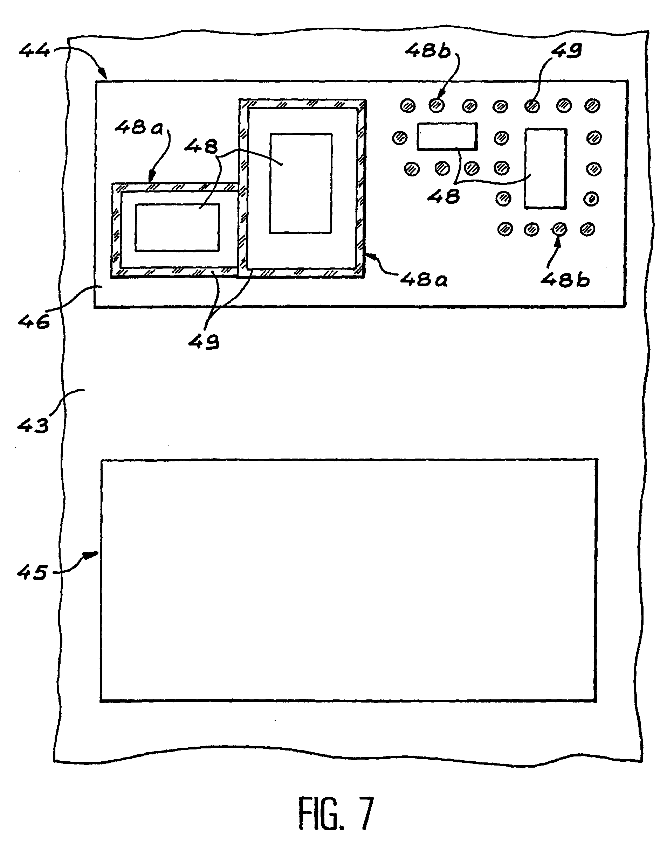

La figure 7 est une vue de dessus schématique d'une structure microélectronique conforme à l'invention.

On voit sur cette figure 7 la surface supérieure d'un substrat 43 dans lequel est formé un élément de basse tension 44 et un élément de haute tension 45.

L'élément 44 est constitué par un caisson P référencé 46 contenant diverses zones 48 où sont formés un ou plusieurs transistors fonctionnant à basse tension.

Dans l'exemple représenté il y a quatre zones 48.

Conformément à l'invention des tranchées 48a et 48b remplies d'un matériau semiconducteur dopé P (si le substrat est de type N) sont formées à travers le caisson P.

Dans l'exemple de la figure 7 ces tranchées entourent les zones 48 où se trouvent le ou les transistors.

Dans le cas de deux des zones les tranchées référencées 48a sont continues et pour les deux autres zones 48 les tranchées référencées 48b sont discontinues.

On a fait diffuser le matériau 49 de remplissage des tranchées 48a et 48b, par exemple le polysilicium dopé P, vers l'extérieur de ces tranchées pour réaliser comme on l'a vu précédemment des zones de type de dopage opposé à celui du substrat (N dans cet exemple).

On éloigne ainsi de l'élément de basse tension 44 (qui constitue par exemple un élément logique de commande) les lignes de potentiel provenant du substrat 43.

Un effet d'écran est d'autant mieux obtenu que les points à protéger sont plus proches d'une tranchée profonde dopée.

Un autre avantage réside dans le fait que les tranchées dopées constituent des résistances électriques faibles qui drainent efficacement les porteurs de type P provenant du substrat.

Ceci protège aussi les transistors.

Dans ce cas également l'effet est d'autant plus fort que les tranchées sont plus profondes et plus rapprochées les unes des autres.

## Revendications

1. Structure microélectronique comprenant :
- au moins un élément de basse tension (2, 44) et au moins un élément de haute tension (4, 45) qui sont formés sur un substrat semiconducteur (6, 43) ayant un premier type de dopage et
- des moyens de protection destinés à protéger l'élément de basse tension contre les effets parasites engendrés au niveau de l'élément de haute tension,
les moyens de protection comprennent :
- au moins une tranchée (18, 48a-48b) pénétrant dans le substrat et traversant l'élément de basse tension, cette tranchée étant remplie au moins partiellement d'un matériau semiconducteur dopé de type opposé au type de dopage du substrat,
- une zone semiconductrice (22, 49) qui est dopée de type opposé au type de dopage du substrat et qui au moins entoure les parois de la ou des tranchées de façon à ce que cette ou ces tranchées permettent de drainer les courants parasites engendrés au niveau de l'élément de haute tension, et
- une prise de contact (24) sur cette zone et/ou sur la tranchée, cette prise de contact permettant la sortie des courants parasites.

2. Structure microélectronique selon la revendication 1, dans laquelle l'élément de basse tension comprend un caisson semiconducteur ayant le deuxième type de dopage et chaque tranchée est formée dans ce caisson.

3. Structure microélectronique selon la revendication 1, dans laquelle ladite zone est une partie du substrat et est dopée par un dopant de type opposé au reste du substrat, tout autour de la tranchée.

4. Structure microélectronique selon la revendication 3, dans laquelle la prise de contact sur cette partie est réalisée par un dépôt conducteur.

5. Structure microélectronique selon la revendication 4, dans laquelle le dépôt conducteur remplit partiellement la tranchée.

6. Structure microélectronique selon la revendication 1, dans laquelle ladite zone comporte un matériau semi-conducteur, de type de dopant opposé à celui du substrat, déposé dans la tranchée, ce matériau remplissant totalement ou partiellement celle-ci et la partie du substrat au voisinage des parois de la tranchée dans laquelle le dopant a diffusé.

7. Structure microélectronique selon la revendication 6, dans laquelle la prise de contact est réalisée par un dépôt conducteur sur ledit matériau, ce dépôt conducteur étant susceptible de compléter le remplissage de la tranchée.

8. Structure microélectronique selon la revendication 1, dans laquelle la ou les tranchées entourent au moins un composant électronique (48) faisant partie de l'élément de basse tension (44).

9. Structure microélectronique selon l'une quelconque des revendications 1 à 8, dans laquelle au moins une tranchée (48a) est continue.

10. Structure microélectronique selon l'une quelconque des revendications 1 à 8, dans laquelle au moins une tranchée (48b) est discontinue.

11. Structure microélectronique selon l'une quelconque des revendications 1 à 10, dans laquelle la profondeur (H) de chaque tranchée au-delà de l'élément de basse tension va de quelques micromètres à une dizaine de micromètres.

12. Structure microélectronique selon l'une quelconque des revendications 1 à 11, dans laquelle la largeur (L) de chaque tranchée vaut 2 µm à 5 µm.

13. Structure microélectronique selon l'une quelconque des revendications 6 et 7, dans laquelle le substrat (6) est en silicium et le matériau (20) est du polysilicium dopé dont le dopage est opposé à celui du silicium du substrat.

14. Structure microélectronique selon l'une quelconque des revendications 6 et 7, dans laquelle le substrat (6) est en silicium et le matériau comprend du verre dopé dont le dopage est opposé à celui du silicium du substrat.

15. Procédé d'obtention d'une protection d'une structure microélectronique comprenant au moins un élément de basse tension et au moins un élément de haute tension qui sont formés sur un substrat semiconducteur ayant un premier type de dopage, ce procédé comprend les étapes suivantes :
- on forme une couche protectrice (39) à la surface de la structure,
- on forme au moins une tranchée (40) à travers la couche protectrice et l'élément de basse tension,
- on forme une zone semiconductrice présentant un deuxième type de dopage opposé au premier type, au moins autour des parois de la ou des tranchées, de façon à ce que cette ou ces tranchées permettent de draîner les courants parasites engendrés au niveau de l'élément de haute tension, et
- on réalise une prise de contact sur ladite zone, cette prise de contact permettant la sortie des courants parasites.

16. Procédé de protection selon la revendication 15, dans lequel ladite zone est réalisée par implantation dans le substrat à travers les parois, d'un dopant de type opposé à celui du substrat.

17. Procédé de protection selon la revendication 15, dans lequel ladite zone est réalisée par dépôt d'un matériau d'un type de dopage opposé à celui du substrat et traitement thermique de la structure, ce traitement thermique étant apte à faire diffuser le dopant vers l'extérieur de la ou des tranchées (40).

18. Procédé de protection selon l'une quelconque des revendications 15 à 17, dans lequel l'élément de basse tension comprend :
- un caisson semiconducteur (28) ayant le deuxième type de dopage,
- des zones espacées électriquement isolantes (30) à la surface du caisson et
- au moins un composant électronique (32) formé dans le caisson, dans un espace compris entre deux des zones,
et dans lequel les tranchées sont formées à travers des espaces séparant ces deux zones de zones isolantes adjacentes.

## Claims

1. Microelectronic structure comprising:
at least one low voltage element (2, 44) and at least one high voltage element (4, 45) formed on a semiconductor substrate (6, 43) having a first type of doping and
means of protection designed to protect the low voltage element against the effects of interference generated at the high voltage element, the means of protection comprising:
at least one channel (18, 48a-48b) penetrating the substrate and traversing the low voltage element, said channel being at least partly filled with a semiconductor material doped with the opposite type to the doping of the substrate,
a semiconductor zone (22, 49) doped with a type of opposite to the doping type of the substrate and which, at the least, encloses the wall or walls of the channel or channels so that this (these) channel or channels drain off the spurious currents generated at the high voltage element and,
a contact point (24) in this zone and/or on the channel, permitting the discharge of spurious currents.

2. Microelectronic structure according to claim 1, in which the low voltage element includes a semiconductor well having the second doping type and each channel is formed within said well.

3. Microelectronic structure in accordance with claim 1, in which said zone is part of the substrate and is doped by a doping agent of a type opposite to the remainder of the substrate all around the channel.

4. Microelectronic structure according to claim 3, in which the contact point in this part is by a conducting deposit.

5. Microelectronic structure according to claim 4, in which the conducting deposit entirely fills the channel.

6. Microelectronic structure according to claim 1, in which this zone includes a semiconductor material of a doping type opposed to that of the substrate, deposited in the channel, which material fills it fully or partially, and the part of the substrate near the walls of the channel in which the doping agent has been diffused.

7. Microelectronic structure according to claim 6, in which the contact point is obtained by a conducting deposit on said material, which conducting deposit is liable to complete the filling of the channel.

8. Microelectronic structure according to claim 1, in which the channel or channels enclose at least one electronic component (48) forming part of the low voltage element (44).

9. Microelectronic structure according to any of claims 1 to 8, in which at least one channel (48a) is continuous.

10. Microelectronic structure according to any of claims 1 to 8, in which at least one channel (48b) is discontinuous.

11. Microelectronic structure according to any of claims 1 to 10, in which the depth (H) of each channel beyond the low voltage element ranges from a few micrometers to ten or so micrometers.

12. Microelectronic structure according to any one of claims 1 to 11, in which the width (W) of each channel is 2 µm to 5 µm.

13. Microelectronic structure according to either of the claims 6 and 7, in which substrate (6) is of silicon and the material (20) is of doped polysilicon, the doping of which is opposite to that of the substrate silicon.

14. Microelectronic structure according to either of the claims 6 and 7, in which the substrate (6) is of silicon and the material comprises doped glass with doping opposite to that of the substrate silicon.

15. Process protecting a microelectronic structure comprising at least one low voltage element and one high voltage element formed on a semiconductor substrate having a first type of doping, said process comprising the following stages:
a protective coat (39) is formed at the surface of the structure,
at least one channel (40) is formed through the protective coating and the low voltage element,
a semiconductor zone is formed offering a second type of doping, opposite to the first type, at least around the walls of the channel or channels so that said channel or channels drain off the spurious currents generated at the high voltage element, and a contact point is established between said zone, which contact point permits the discharge of spurious currents.

16. Protection process according to claim 15, in which said zone is obtained by implanting into the substrate through the walls, a doping agent of a type opposite that of the substrate.

17. Protection process according to claim 15, in which said zone is obtained by the deposit of a material of a doping type opposite that of the substrate and by heat treatment of the structure, which heat treatment is apt to cause the doping agent to diffuse towards the outside of channel or channels (40).

18. Process of protection according to any of claims 15 to 17, in which the low voltage element includes:
• a semiconductor well (28) with the second type of doping,
• areas spaced electrically and insulated (30) at the surface of the well and
• at least one electric component (32) formed in the well in the space included between two of the zones and in which the channels are formed through spaces separating these zones from the adjacent insulating zones.

## Patentansprüche

1. Mikroelektronik-Struktur, die umfasst:
- mindestens ein Element mit niedriger Spannung (2, 44) und mindestens ein Element mit hoher Spannung (4, 45), die aus einem Halbleiter-Substrat (6, 43) mit einem ersten Dotierungs-Typ hergestellt sind, und
- Schutzeinrichtungen, um das Element mit niedriger Spannung gegen die störenden Effekte zu schützen, die im Bereich des Elements mit hoher Spannung entstehen, wobei die Schutzeinrichtungen umfassen:
- mindestens einen Einschnitt (Graben) (18, 48a-48b), der in das Substrat eindringt und das Element mit niedriger Spannung durchquert, wobei dieser Einschnitt mindestens teilweise mit einem Halbleitermaterial eines Dotierungs-Typs gefüllt ist, der entgegengesetzt zum Typ der Dotierung des Substrats ist,
- eine halbleitende Zone (22, 49) von einem Dotierungs-Typ, der entgegengesetzt ist zum Dotierungs-Typ des Substrats, welche mindestens die Wände des oder der Einschnitte in der Weise umgibt, dass dieser oder diese Einschnitte die Ableitung der Störströme erlauben, die im Bereich des Elements mit hoher Spannung auftreten, und
- eine Kontaktstelle (24) auf dieser Zone und/oder auf dem Einschnitt,
wobei diese Kontaktstelle das Austreten der Störströme erlaubt.

2. Mikroelektronik-Struktur nach Anspruch 1, in der das Element mit niedriger Spannung einen Halbleiter-Caisson mit einem zweiten Dotierungs-Typ umfasst und jeder Einschnitt in diesem Caisson vorliegt.

3. Mikroelektronik-Struktur nach Anspruch 1, in der die genannte Zone ein Teil des Substrats ist und mit einem Dotierungsmittel eines Typs dotiert ist, der entgegengesetzt ist zum Rest des Substrats um den Einschnitt herum.

4. Mikroelektronik-Struktur nach Anspruch 3, in der die Kontaktstelle auf diesem Abschnitt durch eine Leiter-Abscheidung gebildet ist.

5. Mikroelektronik-Struktur nach Anspruch 4, in der die Leiter-Abscheidung den Einschnitt teilweise ausfüllt.

6. Mikroelektronik-Struktur nach Anspruch 1, in der die Zone ein HalbleiterMaterial mit einem Typ eines Dotierungsmittels umfasst, der entgegengesetzt zu demjenigen des Substrats ist, der in dem Einschnitt abgeschieden ist, wobei dieses Material diesen und den Abschnitt des Substrats in der Nähe der Wände des Einschnittes, in den das Dotierungsmittel diffundiert ist, teilweise oder vollständig ausfüllt.

7. Mikroelektronik-Struktur nach Anspruch 6, in der die Kontaktstelle durch eine Leiterabscheidung auf dem Material gebildet ist, wobei diese Leiterabscheidung die Auffüllung des Einschnitts vervollständigen kann.

8. Mikroelektronik-Struktur nach Anspruch 1, in welcher der oder die Einschnitte mindestens ein elektronisches Bauelement (48) umgeben, das Teil des Elements mit niedriger Spannung (44) ist.

9. Mikroelektronik-Struktur nach einem der Ansprüche 1 bis 8, in der mindestens ein Einschnitt (48a) kontinuierlich (durchgehend) ist.

10. Mikroelektronik-Struktur nach einem der Ansprüche 1 bis 8, in der mindestens ein Einschnitt (48b) diskontinuierlich ist.

11. Mikroelektronik-Struktur nach einem der Ansprüche 1 bis 10, in der die Tiefe (H) jedes Einschnitts über das Element mit niedriger Spannung hinaus einige µm bis zu einigen 10 µm beträgt.

12. Mikroelektronik-Struktur nach einem der Ansprüche 1 bis 11, in der die Breite (L) jedes Einschnitts 2 µm bis 5 µm beträgt.

13. Mikroelektronik-Struktur nach einem der Ansprüche 6 und 7, in der das Substrat (6) aus Silicium ist und das Material (20) aus dotiertem Polysilicium ist, dessen Dotierung entgegesetzt zu derjenigen des Siliciums des Substrats ist.

14. Mikroelektronik-Struktur nach einem der Ansprüche 6 und 7, in der das Substrat (6) aus Silicium ist und das Material dotiertes Glas umfasst, dessen Dotierung entgegesetzt zu derjenigen des Siliciums des Substrats ist.

15. Verfahren zur Herstellung eines Schutzes für eine Mikroelektronik-Struktur, die mindestens ein Element mit niedriger Spannung und mindestens ein Element mit hoher Spannung umfasst, die auf einem Halbleiter-Substrat gebildet werden, das einen ersten Dotierungs-Typ aufweist, wobei dieses Verfahren die folgenden Stufen umfasst:
- man erzeugt an der Oberfläche der Struktur mindestens eine Schutzschicht (39),
- man erzeugt mindestens einen Einschnitt (Graben) (40) durch die Schutzschicht und das Element mit niedriger Spannung hindurch,
- man erzeugt eine Halbleiterzone, die einen zweiten Dotierungs-Typ aufweist, der entgegengesetzt zu dem ersten Dotierungs-Typ ist, mindestens um die Wände des oder der Einschnitte herum in der Weise, dass dieser oder diese Einschnitte die Abführung der Störströme erlaubt (erlauben), die im Bereich des Elements mit hoher Spannung auftreten, und
- man stellt eine Kontaktstelle auf der gennanten Zone her, wobei diese Kontaktstelle den Austritt der Störströme erlaubt.

16. Schutzverfahren nach Anspruch 15, bei dem die genannte Zone durch Implantation eines Dotierungsmittels eines Typs, der entgegengesetzt zu demjenigen des Substrats ist, in dem Substrat durch die Wände hindurch hergestellt wird.

17. Schutzverfahren nach Anspruch 15, bei dem die genannte Zone hergestellt ist durch Abscheidung eines Materials eines Typs eines Dotierungs-Typs, der entgegengesetzt zu demjenigen des Substrats ist, und eine thermische Behandlung der Struktur, wobei diese thermische Behandlung dazu bestimmt ist, das Dotierungsmittel in das Innere des des Einschnitts oder der Einschnitte (40) diffundieren zu lassen.

18. Schutzverfahren nach einem der Ansprüche 15 bis 17, bei dem das Element mit niedriger Spannung umfasst:
- einen Halbleiter-Caisson (28), welcher den zweiten Dotierungs-Typ aufweist,
- im Abstand voneinander angeordnete elektrisch isolierende Zonen (30) an der Oberfläche des Caissons und
- mindestens ein elektronisches Bauelement (32), das in dem Caisson in einem Zwischenraum zwischen zwei der Zonen vorliegt und in dem die Einschnitte durch die Zwischenräume hindurch, die diese beiden Zonen von den benachbarten isolierenden Zonen trennen, gebildet werden.
